# DEMANDE DE BREVET EUROPEEN

(11) **EP 1 111 675 A1**
(43) Date de publication de la demande: **27.06.2001**
(21) Numéro de dépôt: 00410158.0
(22) Date de dépôt: 21.12.2000
(51) Int. Cl.: H01L 23/60, H01L 27/02, H01L 27/12

(54) **Dispositif de protection d'une structure soi**

(30) Priorité: 22.12.1999 FR 9916289
(71) Demandeur: STMicroelectronics S.A., 94250 Gentilly (FR)
(72) Inventeur: Gimonet, Sophie, 37270 Veretz (FR)
(74) Mandataire: de Beaumont, Michel

(57) **Abrégé**

L'invention concerne un dispositif de protection d'une structure de type SOI comportant plusieurs cellules isolées (11-16), chaque cellule étant constituée d'une portion de substrat semiconducteur d'un premier type de conductivité dont le fond (21) et les parois latérales (23) sont délimités par une zone isolante. Une cellule de protection (15) comporte une première région semiconductrice (40) du deuxième type de conductivité relié à un potentiel de référence et plusieurs deuxièmes régions (41-44, 46-49) du deuxième type de conductivité séparées les unes des autres et de la première région. La portion de substrat de chacune des cellules autre que la cellule de protection est connectée à l'une des deuxièmes régions.

## Description

La présente invention concerne la protection de structures de type silicium sur isolant (SOI), c'est-à-dire des cellules dont les fonds et les parois sont isolés par un matériau diélectrique et dans lesquelles différents composants ou groupes de composants élémentaires sont disposés. On s'intéressera plus particulièrement à la protection de ces cellules contre des décharges électrostatiques, susceptibles de les détériorer par claquage en tension.

Actuellement, les technologies SOI sont principalement utilisées dans les domaines des circuits intégrés en faible et moyenne tension, c'est-à-dire des circuits destinés à supporter au plus des tensions de l'ordre de la dizaine de volts. Dans ces circuits intégrés, les composants élémentaires étant de plus en plus petits, ils deviennent de plus en plus sensibles aux décharges électrostatiques. Ainsi, de façon classique, un système de protection contre les décharges électrostatiques est souvent prévu sur toutes les entrées/sorties des diverses cellules du circuit intégré.

Un problème spécifique se pose dans le cas où une technologie SOI est utilisée pour la réalisation de circuits comprenant des composants de forte puissance auxquels est susceptible d'être appliquée une tension élevée. Dans ce cas, en fonctionnement normal, on peut trouver des différences de plusieurs centaines de volts entre deux cellules voisines. Il faut alors protéger ces cellules et il faut que le circuit de protection soit calibré pour ne pas se déclencher lors du fonctionnement normal du dispositif mais pour se déclencher avant que ces hautes tensions ne dépassent un seuil déterminé.

La présente invention vise plus particulièrement à résoudre le problème de la protection des oxydes entre cellules ou de fond de cellules dans le cas où la structure comporte des cellules susceptibles de supporter normalement des hautes tensions.

Pour atteindre cet objet, la présente invention prévoit un dispositif de protection d'une structure de type SOI comportant plusieurs cellules isolées, chaque cellule étant constituée d'une portion de substrat semiconducteur d'un premier type de conductivité dont le fond et les parois latérales sont délimités par une zone isolante, comprenant une cellule de protection qui comporte une première région semiconductrice du deuxième type de conductivité reliée à un potentiel de référence et plusieurs deuxièmes régions du deuxième type de conductivité séparées les unes des autres et de la première région, la portion de substrat de chacune des cellules autre que la cellule de protection étant connectée à l'une des deuxièmes régions.

Selon un mode de réalisation de la présente invention, le fond et les parois de chacune des cellules comportent une région périphérique du premier type de conductivité à fort niveau de dopage.

Selon un mode de réalisation de la présente invention, la connexion de chaque cellule à la cellule de protection comprend une région du premier type de conductivité à fort niveau de dopage, en continuité avec ladite région de dopage périphérique.

Selon un mode de réalisation de la présente invention, la couche de face arrière de la structure SOI est également reliée à l'une des deuxièmes régions.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un exemple de structure SOI ;
la figure 2 représente une vue en coupe schématique d'une cellule de protection selon la présente invention ; et
la figure 3 représente une vue de dessus schématique d'une structure de protection selon la présente invention.

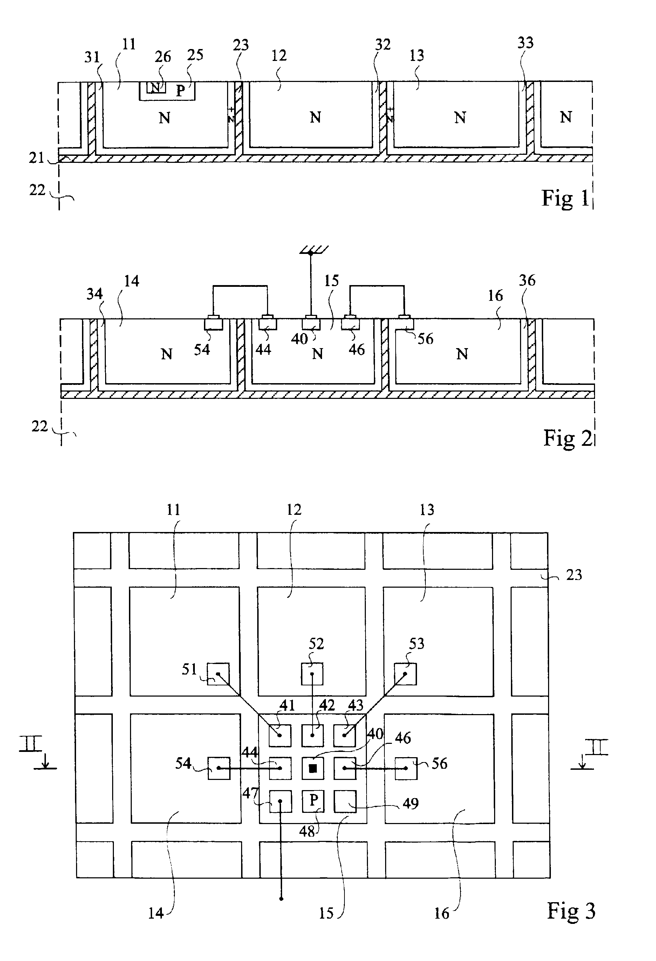

Conformément à l'usage dans le domaine de la représentation des composants semiconducteurs, les diverses figures se sont pas tracées à l'échelle. En outre, l'échelle n'est pas non plus respectée entre la vue en coupe de la figure 2 et la vue de dessus de la figure 3.

La figure 1 représente un exemple de structure SOI classique. Chaque cellule comprend une portion d'un substrat de type N 11, 12, 13. Le fond de chaque cellule est isolé par une couche diélectrique, couramment une couche d'oxyde de silicium 21, d'une plaquette inférieure 22, couramment une tranche de silicium. Les parois latérales de chaque cellule sont isolées par des tranchées 23 dont les parois sont revêtues d'un diélectrique. Entre chaque portion de substrat 11, 12, 13 et la couche d'oxyde de silicium constituant le fond et les parois de cette portion de caisson est formée une région de type N fortement dopée, respectivement 31, 32, 33. Les régions 31, 32, 33 ont notamment pour effet d'éviter l'accumulation de charges aux bords des couches d'oxyde de silicium.

Une façon de réaliser la structure de la figure 1 consiste à partir de deux plaquettes de silicium. Une première plaquette de silicium 22 a sa face supérieure revêtue d'une couche d'oxyde 21. On réalise du côté de la face supérieure d'une deuxième plaquette de silicium une implantation de type N⁺ avant d'oxyder sa surface. Après quoi, la deuxième plaquette de silicium est collée par sa face supérieure sur la face supérieure de la plaquette de silicium 22. On arase alors la face apparente de la deuxième plaquette pour arriver à une épaisseur souhaitée. Des tranchées sont gravées dans la deuxième plaquette puis on procède à un dopage de type N (pour former les côtés des régions 31-33) et à une oxydation des parois des tranchées qui sont ensuite remplies de silicium polycristallin.

En outre, on a représenté en figure 1, dans la cellule isolée 11 une région 25 de type P contenant une région 26 de type N. Ceci pourra par exemple constituer un transistor de puissance vertical dont l'émetteur correspond à la région 42, la base à la région 41 et le collecteur au substrat 11. Le contact de collecteur sera repris annulairement sur la partie de région N⁺ 31. Ceci constitue seulement un exemple de composant réalisable dans une cellule isolée. Il s'agit là d'un composant de puissance qui, si l'épaisseur des portions de silicium 11, 12, 13 est de l'ordre de 60 *µ*m, peut avoir une tension de claquage de l'ordre de 600 volts. Se pose alors le problème d'évacuer d'éventuelles décharges électrostatiques tout en maintenant la possibilité d'isolement pour une valeur au moins égale à 600 volts entre deux cellules adjacentes.

Pour résoudre ce problème, comme l'illustrent les figures 2 et 3, la présente invention prévoit d'affecter l'une des cellules de la structure SOI à une fonction de protection centralisée.

La figure 2 représente une vue en coupe selon la ligne II-II de la figure 3. En figure 3, on a représenté six cellules 11 à 16, la cellule 15 étant dédiée à la fonction de protection. Les tranchées séparant les divers caissons sont désignés globalement par la référence 23, et on n'a pas représenté en figure 3 les régions de type N fortement dopées disposées au voisinage du fond et des parois de chaque cellule.

La cellule 15 comprend, dans l'exemple représenté, neufs régions de type P 40-44 et 46-49. La région 40 est une région centrale 40 reliée à la masse ou autre potentiel de référence. Les régions 41 à 44 et 46 sont reliées à des prises de contact 51 à 54 et 56 constituées de régions fortement dopées de type N formées dans les portions de substrat respectives 11 à 14 et 16. Une région de type P 47 est connectée à une métallisation de face arrière de la tranche de silicium 22, par exemple par un fil de liaison entre la métallisation 47 et le boîtier et une connexion du boîtier à la face arrière. Les deux dernières régions 48, 49 pourront être omises ou seront connectées à d'autres régions à protéger, par exemple à une autre portion d'une même cellule. Bien entendu, de façon classique, les connexions entre régions situées sur la même face du substrat seront réalisées par des métallisations isolées.

La figure 2 représente deux exemples de disposition de prises de contact avec des portions de substrat. La prise substrat 54 est constituée d'une région N⁺ disjointe de la périphérie 34 fortement dopée de type N de la cellule. Par contre, dans la cellule 16, la prise substrat 56 constitue un prolongement de la région fortement dopée de type N 36 entourant la cellule.

Egalement, en considérant la cellule 15 dans la vue en coupe de la figure 2, on constate que chacune des régions P 44 et 46 constitue avec la région P 40, dont elle est séparée par une région N, une diode à avalanche bidirectionnelle. Cette diode à avalanche ayant le même substrat N que celui de chacune des cellules actives, sa tension de claquage, dans chacune des directions, sera la même que la tension de claquage de chacun des composants de puissance éventuellement formés dans certaines des autres cellules. Ainsi, on est assuré qu'il n'y aura pas de claquage prématuré quand une forte tension "normale" est appliquée sur l'une des cellules, en l'absence d'impulsion électrostatique. On notera en outre que, comme pour les composants de puissance formés dans les autres cellules, les diodes de protection auront, au moins partiellement, un fonctionnement vertical.

Ainsi, le composant de protection selon l'invention a les propriétés suivantes :
- étant intégré sur le même substrat que les autres cellules, il ne présentera pas de claquage prématuré en fonctionnement normal,
- si sa tenue aux décharges électrostatiques est choisie supérieure à celle des diélectriques des diverses cellules et à la spécification des divers composants, il déviera les décharges électrostatiques.

Bien entendu, la présente invention est susceptible de diverses variantes et modifications qui apparaîtront à l'homme de l'art. En particulier, la disposition des diverses régions de type P dans la cellule de protection 15 pourra être choisie par l'homme de l'art pour optimiser divers paramètres.

## Revendications

1. Dispositif de protection d'une structure de type SOI comportant plusieurs cellules isolées (11-16), chaque cellule étant constituée d'une portion de substrat semiconducteur d'un premier type de conductivité dont le fond (21) et les parois latérales (23) sont délimités par une zone isolante, caractérisé en ce qu'il comprend une cellule de protection (15) qui comporte une première région semiconductrice (40) du deuxième type de conductivité reliée à un potentiel de référence et plusieurs deuxièmes régions (41-44, 46-49) du deuxième type de conductivité séparées les unes des autres et de la première région et en ce que la portion de substrat de chacune des cellules autre que la cellule de protection est connectée à l'une des deuxièmes régions.

2. Dispositif de protection selon la revendication 1, caractérisé en ce que le fond et les parois de chacune des cellules comportent une région périphérique (31-33) du premier type de conductivité à fort niveau de dopage.

3. Dispositif de protection selon la revendication 2, caractérisé en ce que la connexion de chaque cellule à la cellule de protection comprend une région (51-54, 56) du premier type de conductivité à fort niveau de dopage, en continuité avec ladite région de dopage périphérique.

4. Dispositif de protection selon la revendication 1, caractérisé en ce que la couche de face arrière de la structure SOI est également reliée à l'une des deuxièmes régions.
